Europäisches Patentamt

European Patent Office

Office européen des brevets

(11) Numéro de publication: **0 500 168 A1**

## DEMANDE DE BREVET EUROPEEN

(21) Numéro de dépôt: 92200373.6

(51) Int. Cl.5: **G06K 19/06**

(22) Date de dépôt: **08.02.92**

(30) Priorité: **18.02.91 FR 9101904**

(43) Date de publication de la demande:
**26.08.92 Bulletin 92/35**

(84) Etats contractants désignés:
**AT DE ES FR GB IT SE**

(71) Demandeur: **SCHLUMBERGER INDUSTRIES**
**50, avenue Jean Jaurès**
**F-92120 Montrouge(FR)**

(72) Inventeur: **Rose, René**
**15, rue de l'Etang**
**F-78190 Voisin-Le-Bretonneux(FR)**

(54) Procédé de fabrication d'un module électronique pour carte à mémoire et module électronique ainsi obtenu.

(57) L'invention concerne un procédé de fabrication de modules électroniques pour carte à mémoire électronique et des modules électroniques ainsi obtenus.

On part d'une bande métallique (10) sur laquelle des motifs sont découpés et des pastilles semi-conductrices (40) sont fixées. Cet ensemble est placé dans la cavité (58, 66) d'un moule par transfert (52, 53, 54). La cavité comporte deux portions (58, 66) disposées de part et d'autre de la bande pour assurer une bonne liaison mécanique entre les éléments conducteurs du motif avant son découpage du reste de la bande (10).

fig_2

Rank Xerox (UK) Business Services

La présente invention a pour objet un procédé de fabrication d'un module électronique pour carte à mémoire et des modules électroniques tels qu'obtenus par la mise en oeuvre de ce procédé.

Comme celà est bien connu une carte à mémoire électronique se compose essentiellement d'un corps de carte de forme sensiblement rectangulaire réalisé en matériau plastique et d'un module électronique fixé sur le corps de la carte, ce module électronique étant essentiellement constitué par un élément support et une pastille semiconductrice fixée sur l'élément support.

Plus précisément, l'élément support comporte sur sa face externe des contacts électriques destinés à entrer en contact avec le connecteur du lecteur de carte et sur son autre face une pastille semi-conductrice reliée électriquement, par exemple par des fils conducteurs, aux zones conductrices de l'élément support. Le plus souvent, l'ensemble constitué par la pastille semi-conductrice et les fils conducteurs est enrobé dans un matériau isolant de protection mécanique et d'isolation électrique.

Les cartes à mémoire électronique doivent respecter un certain nombre de caractéristiques définies par des normes très précises telles que la norme ISO 7810. Parmi les spécifications imposées aux cartes, la première réside dans le fait que l'épaisseur de la carte doit se situer dans une fourchette très précise autour de la valeur de 0,8 mm. En conséquence, il est nécessaire que le module électronique ait lui-même une épaisseur très réduite pour pouvoir être fixé dans le corps de la carte. Une deuxième spécification réside dans le fait que la carte équipée de son module électronique doit satisfaire à des tests de flexion et de torsion. Il est donc nécessaire que le module électronique soit correctement fixé pour que celui-ci ne se détache pas du corps de carte sous l'effet des torsions ou des flexions et de, plus, il est nécessaire que le module électronique ait lui-même des propriétés mécaniques convenables pour qu'il ne risque pas lui-même d'être détruit lorsque les contraintes de flexion et de torsion lui sont appliquées.

Parmi les cartes électroniques fabriquées maintenant, un grand nombre sont dites jetables, c'est-à-dire que lorsque les circuits mémoire des circuits intégrés réalisés dans le module électronique de la carte sont saturés, la mémoire ne peut pas être rechargée et la carte devient donc inutilisable. C'est typiquement le cas pour les cartes à mémoire servant dans les téléphones à prépaiement par cartes. On comprend que dans ce cas il est nécessaire que le coût de fabrication de la carte soit aussi réduit que possible de telle manière que le coût de fabrication ne représente qu'un faible pourcentage du prix de vente global de la carte fournie à l'usager, ce prix de vente incluant essentiellement le montant de prestations auxquelles l'usager aura droit en utilisant sa carte.

L'élément support du module électronique est, dans les cartes actuelles, le plus souvent réalisé à l'aide d'un circuit imprimé dont la couche métallique externe est gravée pour définir les différentes plages de contact externes de la carte. Cependant, cette technique est relativement onéreuse. C'est pourquoi on a déjà proposé dans la demande de brevet européenne 0 254 640 de réaliser l'élément support à l'aide d'un cadre conducteur, plus communément désigné sous le vocable anglo-saxon de "Lead Frame".

Selon la technique décrite dans la demande européenne citée ci-dessus, on réalise dans une bande métallique conductrice une succession de motifs correspondant chacun à la réalisation d'un module électronique. Par découpage, on sépare les unes des autres les différentes plages de contact électrique externes, les éléments conducteurs ainsi obtenus restent mécaniquement reliés au reste de la bande métallique par des ponts de dimensions réduites. Dans une première étape, on fixe la pastille semi-conductrice sur un des éléments conducteurs puis on procède à l'enrobage de la pastille semi-conductrice, afin de protéger celle-ci et de réaliser une liaison mécanique isolante entre les extrémités des éléments conducteurs. Il suffit alors de découper les ponts pour obtenir un module électronique.

La présente invention a pour objet un procédé de réalisation de module électronique pour carte à mémoire utilisant également la technique du leadframe mais permettant d'utiliser un lead-frame d'épaisseur réduite tout en assurant une liaison mécanique entre les éléments conducteurs encore améliorée.

Pour atteindre ce but, le procédé de réalisation de module électronique se caractérise en ce qu'il comprend les étapes suivantes :

on fournit une bande en un matériau métallique présentant une première et une deuxième faces ;

on découpe ladite bande pour former une pluralité de motifs, chaque motif correspondant à un module, définissant une pluralité d'éléments conducteurs plans phériphériques isolés les uns des autres et reliés mécaniquement au reste de ladite bande par des ponts et un élément conducteur central relié à un des éléments périphériques, la première face de chaque élément conducteur périphérique formant un contact externe, chaque élément conducteur comportant une extrémité de fixation proche desdits ponts et une extrémité de connexion ;

on fixe sur la deuxième face de l'élément conducteur central une pastille semi-conductrice et on relie électriquement les bornes de ladite pastille aux extrémités de connexion ;

on place ledit motif de ladite bande dans un moule de transfert dont la cavité comprend deux portions de cavité s'étendant de part et d'autre de ladite bande métallique ;

on introduit dans ledit moule une résine de moulage pour que celle-ci remplisse lesdites portions de cavité et pénètre dans les découpes de la bande métallique, lesdites découpes dans la région des zones de connexion présentant des dimensions suffisantes pour permettre le passage de ladite résine d'une portion de cavité dans l'autre ; et

on ouvre le moule et on sépare par coupage desdits ponts ledit motif du reste de la bande métallique.

On comprend qu'ainsi les éléments conducteurs plats sont fermement maintenus entre eux par leur extrémité de connexion grâce à la résine de moulage qui est présente de part et d'autre de ces éléments. En outre, l'introduction de la résine dans le moule se faisant sous une surpression très réduite, les éléments conducteurs ne risquent pas d'être déformés, ce qui autorise l'utilisation d'une bande métallique d'épaisseur réduite.

L'invention concerne également un module électronique comprenant un ensemble d'éléments conducteurs plans périphériques dont la première face forme un contact externe et un élément conducteur central relié à un des éléments périphériques, la deuxième face de chaque élément périphérique définissant une extrémité de connexion et une extrémité de fixation, une pastille semi-conductrice fixée sur la deuxième face de l'élément central, des moyens de connexion électrique des bornes de la pastille aux extrémités de connexion des éléments conducteurs et un enrobage en matériau isolant qui se caractérise en ce que ledit matériau d'enrobage s'étend sur la première face des éléments conducteurs pour recouvrir ledit élément central et seulement les extrémités de connexion des éléments périphériques et sur la deuxième face des éléments conducteurs pour recouvrir ladite pastille semi-conductrice mais laisser dégagées lesdites extrémités de fixation, le matériau d'enrobage s'étendant sur ladite première face ayant une épaisseur comprise entre 0,04 mm et 0,08 mm.

D'autres caractéristiques et avantages de l'invention apparaîtront plus clairement à la lecture de la description qui suit d'un mode préféré de mise en oeuvre de l'invention donné à titre d'exemple non limitatif. La description se réfère aux dessins annexés sur lesquels :

- la figure 1 est une vue de dessus d'une partie de la bande métallique utilisée dans l'invention ;
- la figure 2 est une vue en coupe verticale d'un moule de transfert utilisable pour la mise en oeuvre du procédé selon l'invention ;
- la figure 3 est une vue de dessous d'un module électronique selon l'invention ; et
- la figure 4 est une vue en coupe verticale selon la ligne IV-IV de la figure 3.

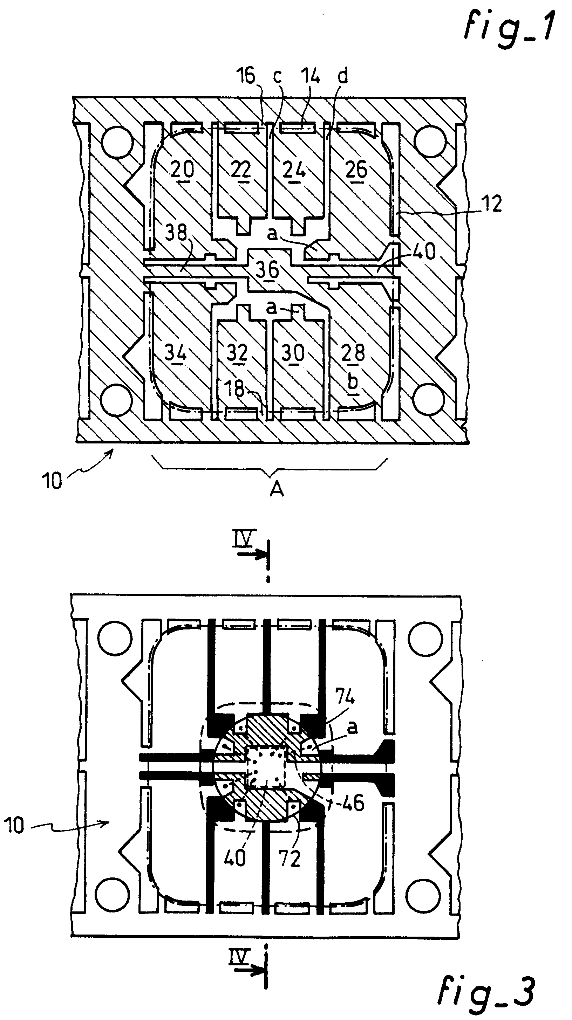

Sur la figure 1, on a représenté une portion d'une bande métallique 10 qui est utilisée pour la fabrication du module électronique. Cette bande métallique a une épaisseur de 0,08 à 0,1 mm. Cette épaisseur est donc réduite par rapport à celle des lead-frame utilisés habituellement dont l'épaisseur est de l'ordre de 0,2 mm. Le métal utilisé est de préférence soit un bronze, soit un maillechart, mais il peut être un autre alliage à base de cuivre.

Dans la bande 10, on a découpé des fentes de séparation telles que 12 et 14 qui séparent partiellement un motif de lead-frame A du reste de la bande métallique 10. Les fentes 12 et 14 définissent une forme sensiblement rectangulaire. Comme on le voit sur la figure 1, les fentes 12 ou 14 sont séparées les unes des autres par des ponts 16, 18 qui relient ainsi mécaniquement l'ensemble du motif A au reste de la bande 10. A l'intérieur du motif A, la bande métallique est découpée pour isoler les uns des autres les différents contacts électriques que doit comporter le module électronique. Selon l'exemple représenté sur la figure 1, on trouve huit contacts électriques référencés 20, 22, 24, 26, 28, 30, 32 et 34. Il faut remarquer que le contact électrique 28 se prolonge par un contact central 36 sur lequel on fixe la pastille semi-conductrice du module électronique comme celà sera expliqué ultérieurement. Chaque contact électrique ou élément conducteur 20 à 34 comporte une extrémité de connexion référencée a qui est proche du contact central 36 et une extrémité b de liaison mécanique ou de fixation qui est reliée aux ponts 16 ou 18. En outre, le contact central 36 est relié au reste de la bande métallique par deux bandes métalliques 38 et 40.

Comme on le voit sur la figure 1, chaque élément conducteur 20 à 34 est séparé des éléments voisins par deux fentes longitudinales c et d qui s'étendent entre les fentes 14 de séparation du motif A par rapport au reste de la bande 10. Comme on le voit également sur la figure 1, les découpes pratiquées à proximité des extrémités de connexion a des éléments conducteurs 20 à 34 ont une surface relativement importante par rapport aux fentes de séparation c et d. On en expliquera ultérieurement la raison. On observera également que l'extrémité de connexion a de chaque élément conducteur présente des dimensions très réduites par rapport à la partie courante des éléments conducteurs.

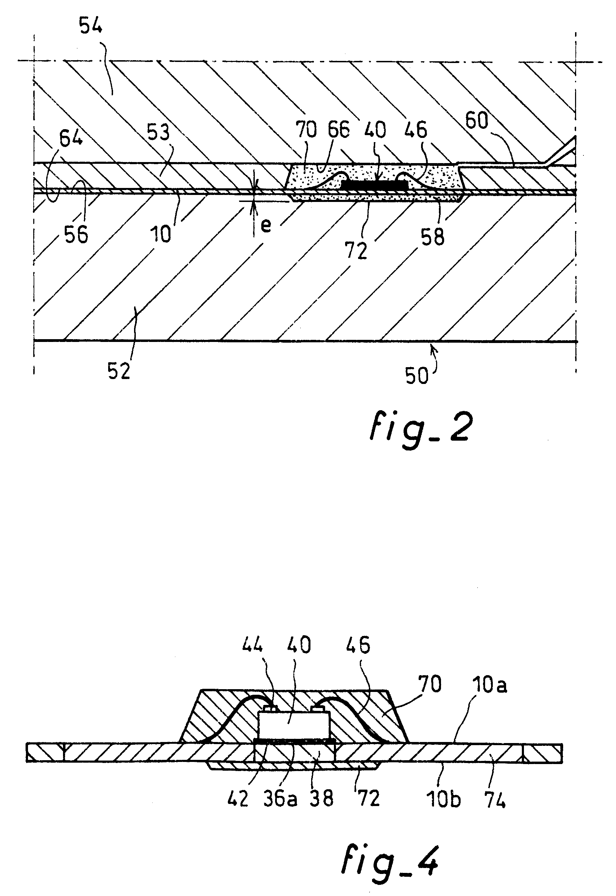

Comme le montre plus particulièrement la figure 4, l'étape suivante du procédé consiste à fixer sur la face antérieure 36a de la zone centrale de connexion 38 une pastille semi-conductrice 40 à l'aide d'une couche de colle conductrice 42. Ainsi, l'élément de contact 36 prolongé par l'élément de contact 28 constitue le contact de masse des circuits électroniques réalisés dans la pastille semi-conductrice 40. Avec certaines technologies de circuits intégrés, il n'est pas nécessaire d'avoir un contact de masse au dos de la pastille semi-conductrice. Dans ce cas, l'élément central 36 constitue seulement un élément de fixation et la colle employée est isolante. Les bornes 44 de la pastille semi-conductrice sont reliées à l'extrémité de connexion a de chaque élément conducteur 20 à 34 par des fils de connexion 46. Sur la figure 3, on a représenté en traits pointillés les fils conducteurs 46 allant des extrémités de connexion a des éléments conducteurs aux bornes de la pastille semi-conductrice 40.

L'étape suivante consiste à réaliser l'enrobage de la pastille 40 et de ces fils conducteurs 46 dans un matériau isolant de protection mécanique. Pour celà, on utilise un moule de transfert 50 représenté sur la figure 2. Le moule 50 comprend une partie inférieure 52, une partie médiane 53 et une partie supérieure 54. La partie 52 présente une face de contact 56 dans laquelle est ménagée une cavité 58 de forme sensiblement cylindrique présentant une profondeur e très réduite de l'ordre de 0,08 mm.

La partie 53 du moule définit partiellement un canal d'injection de résine 60, le canal 60 étant également formé par la partie 54 du moule dans sa face de contact avec la pièce 53. La pièce 53 comporte également une surface d'appui 64 en regard de la face d'appui 56 de la partie 52. Une cavité troncônique 66 est ménagée dans la face 64. La paroi supérieure de la cavité 60 est définie par la partie pleine 54 du moule. La cavité 66 a des dimensions à la base supérieure à celles de la cavité 58. En outre la cavité 66 a des dimensions suffisantes pour pouvoir englober totalement la pastille semi-conductrice 40 et ses fils de connexion 46, ainsi qu'on l'a montré sur la figure 2.

Pour réaliser l'enrobage de la pastille semi-conductrice 40, on place la bande conductrice 10 entre les parties 52 et 53 du moule comme celà est représenté sur la figure 2. Puis on referme le moule, ce qui a pour effet de pincer la périphérie de la bande métallique correspondant au motif A entre les faces d'appui 64 et 56 des parties du moule. Puis on met en place la partie 54. On réalise ainsi une liaison étanche entre ces deux parties et la bande 10. On procède alors à l'admission de la résine de moulage par transfert sous forme liquide. La résine est soit liquide, soit elle est liquéfiée par chauffage et après un temps de solidification convenable on procède au démoulage pour obtenir le module électronique représenté sur les figures 3 et 4.

Lors de l'enlèvement de la partie 54, la carotte de moulage est séparée de l'enrobage 70 alors que le lead-frame est toujours pincé entre les parties 53 et 52 du moule. ainsi la rupture de la carotte de moulage ne peut entraîner l'application d'aucune contrainte au lead-frame.

Compte tenu de la forme de la cavité du moule, on voit que la résine isolante forme un enrobage 70 pour la pastille semi-conductrice 40 qui est disposée sur la face 10a de la bande métallique et dont la forme est bien sûr définie par les parois de la cavité 66 du moule. On trouve une deuxième portion moulée 72 qui est disposée sur la face antérieure 10b de la bande métallique 10 et qui est définie par la cavité 58 de la partie 52 du moule 50. Enfin, la résine pénètre également dans les fentes c et d séparant les éléments conducteurs et dans les différentes ouvertures ménagées dans la région centrale du lead-frame. On a référencé 74 ces parties de matériau moulées. Bien entendu, il existe une solution de continuité entre ces trois parties moulées et la figure 4 ne les représente de façon différente que pour mieux en faire comprendre l'organisation. De même, sur la figure 3, on a représenté en traits hachurés les portions de la partie moulée 74 qui sont masquées par la partie moulée 72 alors que les portions de la partie moulée 74 dégagée ont été représentées en noir.

On comprend que grâce au fait que le matériau d'enrobage dans les zones 70 et 72 se trouve de part et d'autre de la bande métallique 10 et que ces portions d'enrobage débordent bien sûr sur les extrémités de connexion a des différents éléments conducteurs, on obtient un très bon renforcement de la partie centrale du lead-frame dont la bande métallique est au départ pourvue de large ouvertures. On obtient ainsi un module électronique dont les différents éléments conducteurs sont fermement réunis les uns aux autres. La liaison mécanique entre les différents éléments conducteurs 20 à 34 est encore renforcée par la présence du matériau de moulage à l'intérieur des fentes de séparation c et d du moins pour le découpage du module électronique de la bande et sa manipulation pour l'insertion du module dans le corps de carte. On comprend que dans le moule le matériau de moulage 74 remplissent les fentes ne peut déborder de part et d'autre des faces 10a et 10b de la bande métallique puisque celle-ci est pincée entre les faces de contact 64 et 56 du moule de transfert.

Il est important de noter que les extrémités a de connexion de chaque élément conducteur ont une largeur réduite par rapport au reste de l'élément conducteur et notamment par rapport à son extrémité de fixation b et se trouvent noyées dans la masse du matériau d'enrobage formé par les portions d'enrobage 70, 72 et 74. En particulier, seules les extrémités de connexion a sont recouvertes par la portion d'enrobage 72. On obtient ainsi une disposition qui permet le découplage mécanique de la pastille semi-conductrice vis-à-vis des extrémités de fixation b des éléments conducteurs, ces parties de fixation b étant destinées à être fixées sur le corps de carte. En outre, on observe que les ouvertures importantes ménagées dans la bande métallique vers le centre du motif A favorisent l'écoulement du matériau plastique pour passer de la cavité 66 de la partie 54 vers la cavité 58 de la partie 52. Ce passage peut ainsi être réalisé sans altérer la forme des éléments conducteurs. En outre, la technique de moulage choisie se fait sous une surpression très réduite. On peut ainsi éviter toute altération en particulier des fils conducteurs 46 et de leur soudure sur les éléments conducteurs.

L'épaisseur de l'enrobage 72 réalisé sur la face externe du module électronique est de 0,05 à 0,10 mm et de préférence 0,08 mm. Celle de l'enrobage réalisé sur la face interne et entourant la pastille semi-conductrice est de l'ordre de 0,42 mm. L'enrobage 72 est circulaire et présente un diamètre de 5 mm. L'enrobage 70 entourent la pastille semi-conductrice est sensiblement carré et présente un côté égal à 6 mm. Quant à l'ensemble du motif A, il a une forme sensiblement rectangulaire dont les dimensions sont égales à 10,6 mm et 12 mm. De plus, la longueur des parties de connexion des éléments conducteurs est de l'ordre de 0,5 mm alors que la largeur de l'extrémité de connexion et de sa partie courante est de l'ordre de 2 mm.

**Revendications**

1. Procédé de réalisation d'un module électronique pour carte à mémoire, caractérisé en ce qu'il comprend les étapes suivantes :

on fournit une bande (10) en un matériau métallique présentant une première (10a) et une deuxième (10b) faces ;

on découpe ladite bande pour former une pluralité de motifs (A), chaque motif correspondant à un module définissant une pluralité d'éléments conducteurs plans phériphériques (22 à 34) isolés les uns des autres et reliés mécaniquement au reste de ladite bande par des ponts (16, 18) et un élément conducteur central (36) relié à un des éléments périphériques, la première face de chaque élément conducteur périphérique formant un contact externe, chaque élément conducteur comportant une extrémité de fixation (b) proche desdits ponts et une extrémité de connexion (a);

on fixe sur la deuxième face de l'élément conducteur central une pastille semi-conductrice (40) et on relie électriquement (46) les bornes de ladite pastille auxdites extrémités de connexion (a) ;

on place ledit motif (A) de ladite bande dans un moule de transfert (50) dont la cavité comprend deux portions de cavité (58, 66) s'étendant de part et d'autre de ladite bande métallique (10);

on introduit dans ledit moule (50) une résine de moulage pour que celle-ci remplisse lesdites portions de cavité (58, 66) et pénètre dans les découpes (c, d) de la bande métallique (10), lesdites découpes dans la région des zones de connexion (a) présentant des dimensions suffisantes pour permettre le passage de ladite résine d'une portion de cavité dans l'autre ; et

on ouvre le moule et on sépare par coupage desdits ponts (16, 18) ledit motif du reste de la bande métallique.

2. Procédé selon la revendication 1, caractérisé en ce que la partie de cavité du moule (58) disposée en regard de la face externe (10b) du motif (A) de la bande métallique a une profondeur (e) comprise entre 0,05 et 0,08 mm.

3. Procédé selon l'une quelconque des revendications 1 et 2, caractérisé en ce que, pour chaque élément conducteur périphérique (22 à 34), l'extrémité de connexion (a) a une largeur réduite par rapport à l'extrémité de fixation (b).

4. Procédé selon l'une quelconque des revendications 1 à 3, caractérisé en ce que les dimensions des portions de cavité (58, 66) du moule sont choisies pour que seules les extrémités de connexion (a) des éléments conducteurs périphériques soient entièrement noyées dans la résine d'enrobage.

5. Procédé selon l'une quelconque des revendications 1 à 4, caractérisé en ce que ledit moule (50) comprend une première partie (52) définissant la première partie de cavité (58), une deuxième partie (53) définissant la périphérie de la deuxième partie de cavité (66) et une troisième partie (54) définissant la paroi supérieure de la deuxième partie de cavité, lesdites deuxième et troisième parties du moule définissant un canal d'introduction de résine (60), ladite bande (10) étant pincée entre lesdites première (52) et deuxième (53) parties du moule.

6. Module électronique comprenant un ensemble d'éléments conducteurs plans périphériques (22 à 34) sont la première face forme un contact externe et un élément conducteur central relié à un des éléments périphériques, la deuxième face de chaque élément périphérique définissant une extrémité de connexion et une extrémité de fixation, une pastille semi-conductrice fixée sur la deuxième face de l'élément central, des moyens de connexion électrique des bornes de la pastille aux extrémités de connexion des éléments conducteurs et un enrobage en matériau isolant qui se caractérise en ce que ledit matériau d'enrobage s'étend sur la première face des éléments conducteurs pour recouvrir ledit élément central et seulement les extrémités de connexion des éléments périphériques et sur la deuxième face des éléments conducteurs pour recouvrir ladite pastille semi-conductrice mais laisser dégagées lesdites extrémités de fixation, le matériau d'enrobage s'étendant sur ladite première face ayant une épaisseur comprise entre 0,04 mm et 0,08 mm.

fig_1

fig_3

fig_2

fig_4

Office européen
des brevets

# RAPPORT DE RECHERCHE EUROPEENNE

Numero de la demande

EP 92 20 0373

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,X | EP-A-0 254 640 (SCHLUMBERGER INDUSTRIES) <br> * abrégé; revendications 1-14; figures 1,5-6D * <br> * colonne 3, ligne 37 - colonne 4, ligne 5 * | 1,3-4,6 | G06K19/06 |
| A | * colonne 7, ligne 60 - colonne 8, ligne 20 * <br> --- | 5 | |
| A | EP-A-0 340 100 (SCHLUMBERGER INDUSTRIES) <br> * abrégé; figure 5 * <br> * colonne 5, ligne 36 - ligne 52 * <br> --- | 1,5 | |
| A | FR-A-2 439 438 (COMPAGNIE INTERNATIONALE POUR L.INFORMATIQUE CII HONEYWELL BULL) <br> * page 1-3; revendications 1-7; figure 1 * <br> ----- | 1 | |
| | | | **DOMAINES TECHNIQUES RECHERCHES (Int. Cl.5)** <br><br> G06K |

Le présent rapport a été établi pour toutes les revendications

| Lieu de la recherche | Date d'achèvement de la recherche | Examinateur |
|---|---|---|
| LA HAYE | 29 MAI 1992 | BEAUCE G.Y.G. |